# EUROPEAN PATENT APPLICATION

(11) **EP 4 586 749 A1**
(43) Date of publication of application: **16.07.2025**
(21) Application number: 24151545.1
(22) Date of filing: 12.01.2024
(51) Int. Cl.: H05K 5/00, H05K 5/06

(54) **CONTROL DEVICE FOR A VEHICLE AND METHOD OF MANUFACTURING A CONTROL DEVICE FOR A VEHICLE**

(71) Applicant: ZF CV Systems Global GmbH, 3006 Bern (CH)
(72) Inventor: TRACZ, Michal, 50-419 Wroclaw (PL)
(74) Representative: Schäferjohann, Volker

(57) **Abstract**

A control device for a vehicle comprises a printed circuit board and a housing in which the printed circuit board is housed. The housing comprises a molded part (40). The molded part (40) comprises at least one structural feature (43) that projects from or is recessed in an inner surface (41) of the molded part (40) that faces towards the printed circuit board. The housing comprises at least one strip of foam material (70) that adheres to the molded part (40) and that extends along the at least one structural feature (43).

## Description

The invention relates to a control device for a vehicle and a method of manufacturing such a control device. Embodiments of the invention relate to a control device having a housing in which a printed circuit board is arranged, with the housing comprising a frame and a cover for the printed circuit board, and to a manufacturing method for such a control device. Embodiments of the invention relate, in particular to such a control device configured for use in association with a pneumatic vehicle system of a utility vehicle.

Many vehicles comprise one or several control devices having a housing and a printed circuit board accommodated in the housing. The housing may have a multicomponent construction which includes first and second outer shell parts (such as a frame and a cover) which, in combination, form a housing cavity in which the printed circuit board is accommodated. In some instances, it may be desirable for the housing to comprise a material having resiliency characteristics different from those of the outer shell parts.

A control device in which a foam material is mechanically secured on a molded part, e.g., by a friction fit generated when compressing the foam material into a groove of the molded part, may have an unsatisfactory fit and may lack flexibility in positioning the foam material. Insertion of the foam material into the groove upon assembling the molded parts, the foam material, and the printed circuit board to the control device can increase complexity of the assembly process. Such a configuration may also cause an entire control device to be discarded if a mistake occurred when engaging the foam material with the molded part in a friction fit.

Complexity of the assembly is also enhanced when the foam material is attached to a molded part by means of a layer of glue.

DE 10 2021 114 833 A1 discloses a control device having a housing which comprises a frame and a cover, wherein the cover comprises a seal made of a foam material. The foam material is received in a groove of the cover.

It is an object of the invention to provide an enhanced control device for a vehicle and an enhanced technique of manufacturing a control device for a vehicle. It is an object of the invention to provide a control device and manufacturing method that provide enhanced flexibility in positioning a resilient material on a molded part of the control device. It is an optional object of the invention to provide a control device and manufacturing method that allow a weight reduction to be attained for the housing.

A control device and a manufacturing method as recited in the independent claims are provided. Preferred or advantageous embodiments are defined by the dependent claims.

According to an aspect, there is provided a control device for a vehicle. The control device comprises a printed circuit board (PCB) and a housing. The housing comprises a frame and a cover configured for engagement with the frame. The cover and the frame define a housing cavity configured to house the PCB therein. At least one of the frame or the cover comprises a molded part. The molded part has an inner surface facing towards the housing cavity. The molded part comprises at least one structural feature that projects from or is recessed in the inner surface. The housing comprises at least one strip of foam material that adheres to the molded part.

Various effects and advantages are attained by the control device. By providing the at least one strip of foam material that adheres on the molded part, it is possible for the cover or frame to be formed from the molded part and the at least one strip of foam material directly disposed thereon, prior to assembly of the cover, frame, and PCB. By providing the at least one strip of foam material that adheres on the molded part, greater flexibility is attained in positioning the foam material as compared to constructions that rely on a friction fitting compression of the foam material. This offers various concomitant effects, such as allowing the at least one strip of foam material to be arranged on an end face of at least one projection of the structural feature and/or allowing the at least one strip of foam material to be arranged in a groove that does not need to have continuous planar walls to delimit the groove.

The molded part and the at least one strip of foam material may be configured such that the at least one strip of foam material is free from mechanical preloading by the molded part prior to assembly of the cover, the frame, and the PCB.

Thereby, the control device is configured such that the at least one strip of foam material disposed on the molded part is available in its uncompressed state for performing functions such as sealing, mechanical securement of the PCB, vibration damping, or other.

The at least one strip of foam material may adhere to the molded part by an adhesion force of the foam material on the molded part.

Thereby, the control device is configured such that greater flexibility is attained in positioning the foam material as compared to constructions that rely on a friction fitting compression of the foam material. This offers various concomitant effects, such as allowing the at least one strip of foam material to be arranged on an end face of at least one projection of the structural feature and/or allowing the at least one strip of foam material to be arranged in a groove that does not need to have continuous planar walls to delimit the groove.

The at least one strip of foam material may be in direct abutment with the molded part without a glue being interposed between the at least one strip of foam material and the molded part.

Thereby, the control device is configured such that manufacture of the frame or cover that comprises the molded part and the at least one strip of foam material is facilitated. It is not required to dispose a glue layer on the molded part to adhere the at least one strip of foam material to the molded part.

The molded part and the at least one strip of foam material may form an integral unit.

Thereby, the control device is configured such that assembly of the cover, frame, and PCB is facilitated. It is not required for the at least one strip of foam material to be handled as a separate component upon assembly of the cover, frame and PCB to provide the control device.

The at least one strip of foam material may comprise or consist of a silicone rubber. For instance, the choice of the silicone rubber provides for an element absorbing movements caused due to the vibrations in or at the control device.

Thereby, the at least one strip of foam material has a composition suitable to adhere in a wide variety of conventional molded housing part materials.

The housing may comprise an ingress seal configured to reduce or eliminate foreign matter ingress into the housing cavity, wherein the ingress seal comprises a strip of foam material of the at least one strip of foam material.

Thereby, the control device is configured such that provision of an ingress seal is facilitated using a strip of foam material adhering on the molded part. Flexibility in positioning the ingress seal is enhanced by virtue of the strip of foam material adhering on the molded part. When the strip of foam material is arranged in a groove, it is not required for the groove to have continuous planar walls for compressing the strip of foam material to form the ingress seal.

The at least one strip of foam material may comprise a strip of foam material arranged to reduce or eliminate foreign matter ingress into the housing cavity.

Thereby, the control device is configured such that the strip of foam material adhering on the molded part is used to reduce or eliminate foreign matter ingress. Greater flexibility in ingress seal configuration is attained, with the strip of foam material being adhering on the molded part. When the strip of foam material is arranged in a groove, it is not required for the groove to have continuous planar walls for compressing the strip of foam material to form the ingress seal.

The strip of foam material arranged to reduce or eliminate foreign matter ingress may be comprised by one of the frame and the cover and abuts on the other one of the frame and the cover.

Thereby, the control device is configured such that foreign matter ingress is reduced or eliminated while affording ease of assembly and/or flexibility in positioning of the ingress seal.

Alternatively or additionally to an ingress seal, the housing may comprise a damping structure for reducing mechanical vibrations of at least one control device component (such as the PCB), wherein the vibration damping structure comprises a strip of foam material of the at least one strip of foam material.

Thereby, the control device is configured such that the strip of foam material adhering on the molded part is operative to reduce or eliminate mechanical vibrations. Undesired noise generated by mechanical vibrations in the control device during its use can be reduced. The risk of unintentional displacement of the control device component (such as the PCB) is reduced.

The at least one strip of foam material may comprise a strip of foam material in abutment with the PCB.

Thereby, the control device is configured such that the strip of foam material adhering on the molded part is operative to reduce or eliminate mechanical vibrations of the PCB. The risk of unintentional displacement of the PCB during use is reduced.

The PCB may have a first major face and a second major face parallel to the first major face. The strip of foam material in abutment with the PCB may abut on the first major face to secure the PCB with the second major face of the PCB abutting on one or several PCB support members of the housing.

Thereby, the control device is configured such that the strip of foam material adhering on the molded part is operative to reduce or eliminate unintentional displacement of the PCB relative to the one or several PCT support members.

The at least one structural feature may comprise a ribbed structural feature.

The damping structure may comprise several strips of foam material adhering to the molded part. The control device may be configured such that an amount of foam material of the damping structure varies along a circumference of the PCB.

Thereby, the control device is configured such that the amount of foam material (e.g., the number and/or lengths of strips of foam material) may be dependent on the amount (e.g., energy and/or amplitude) of vibration that is to be absorbed by the strips of foam material.

The damping structure may comprise several strips of foam material adhering to the molded part and disposed on free ends of several ribbed projections, wherein the several ribbed projections are spaced from each other and wherein the free ends of the several ribbed projections face towards but are spaced from the PCB.

Thereby, the control device is configured such that the several strips of foam material reduce unintended dislodgment of the PCB at various locations, e.g., at various locations along a PCB edge region.

The damping structure may be configured such that the several strips of foam material are arranged in a non-uniform manner along the PCB edge region.

Thereby, the control device is configured such that the amount of foam material (e.g., the number and/or lengths of strips of foam material) may be dependent on the amount (e.g., energy and/or amplitude) of vibration that is to be absorbed by the strips of foam material.

The ribbed structural feature may project or may be recessed along a first direction relative to an inner surface region of the inner surface (e.g., relative to a planar inner surface region). The ribbed structural feature may extend along a second direction. The first direction may be transverse (e.g., perpendicular or substantially perpendicular) to the inner surface region. The second direction may be parallel to the inner surface region. The ribbed structural feature may have a width measured along a third direction, wherein the third direction is parallel to the inner surface region and transverse (e.g., perpendicular or substantially perpendicular) to the first direction and to the second direction. The width may vary as a function of position along the second direction.

Thereby, the control device is configured such that the molded part has a ribbed structural feature on or otherwise along which the at least one strip of foam material adheres. The control device is configured to harness the fact that the at least one strip of foam material can be disposed directly on or along the ribbed structural feature from a needle that dispenses the foam material. The at least one strip of foam material remains located on or otherwise along the ribbed structural feature, without unacceptable flow into gaps between adjacent ribs of the ribbed structural feature.

The ribbed structural feature may comprise a curved surface segment at an end face of the ribbed structural feature. The at least one strip of foam material comprises a strip of foam material arranged on the curved surface segment.

Thereby, the control device is configured such that the at least one strip of foam material can adhere to the molded part over a larger area, reducing the risk of unintended dislodgement.

The curved surface segment may define a curvature around the second direction. The curved surface segment may comprise a cylinder surface segment of a cylinder having a circular or elliptical base, or may have a parabolic shape, without being limited thereto.

Thereby, the control device is configured such that the at least one strip of foam material can adhere to the molded part over a larger area, reducing the risk of unintended dislodgement, while facilitating deposition of the at least one strip of foam material on the curved surface.

The control device may be configured such that the ribbed structural feature with the at least one strip of foam material disposed thereon is operative to reduce or eliminate foreign matter ingress into the housing cavity and/or to secure the PCB on the PCB retention structure.

Thereby, the control device is configured such that the effects disclosed in association with the at least one strip of foam material adhering on the molded part are attained for providing an ingress seal and/or reducing the risk of unintended dislodgment of the PCB.

The at least one structural feature may comprise a groove in the molded part. The at least one strip of foam material may comprise a strip of foam material arranged in the groove.

Thereby, the control device is configured such that the effects disclosed in association with the at least one strip of foam material adhering on the molded part are attained for a foam material arranged in the groove.

The groove may be a ribbed groove. The ribbed groove may have a ribbed projection comprising several projections on at least one of its sides.

Thereby, the control device is configured to allow the at least one strip of foam material to be dispensed into the ribbed groove from a needle of a foam dispensing system without requiring the groove to be delimited by continuous flat walls on either side. The control device is configured to provide weight benefits associated with the ribbed structure.

The groove may have an extension direction and a groove width measured perpendicular to the extension direction, wherein the groove width varies as a function of position along the extension direction.

Thereby, the control device is configured to provide weight benefits associated with the ribbed structure.

The control device may comprise at least one electric connector operative to receive sensor signals, wherein the control device is operative to generate a pneumatic and/or electric output responsive to the sensor signals.

Thereby, the control device is configured for use in applications (such as brake systems, levelling systems, or other vehicle systems) in which it is particularly desirable to provide ingress reduction and/or reduce PCB movement during control device operation using a control device configuration that allows weight benefits to be attained and/or that provides enhanced versatility in positioning and dimensioning strip(s) of foam materials.

The control device may comprise a control port operative to receive a control pressure, at least one fluid supply port operative to receive pressure gas from a pressure gas reservoir, and at least one consumer port operative to provide pressure gas to a pressure gas consumer (such as a brake cylinder).

Thereby, the control device is configured for use in applications (such as brake systems, levelling systems, or other vehicle systems) in which it is particularly desirable to provide ingress reduction and/or reduce PCB movement during control device operation using a control device configuration that allows weight benefits to be attained and/or that provides enhanced versatility in positioning and dimensioning strip(s) of foam materials.

According to a further aspect, there is provided a vehicle brake valve which comprises the control device of any aspect or embodiment disclosed herein.

The effects of the vehicle brake valve correspond to the effects disclosed in association with the control device.

According to a further aspect, there is provided a pressure modulator for a utility vehicle, wherein the pressure modulator comprises the control device of any aspect or embodiment disclosed herein.

The effects of the pressure modulator correspond to the effects disclosed in association with the control device.

The vehicle brake valve or pressure modulator may comprise a control port operative to receive a control pressure, at least one fluid supply port operative to receive pressure gas from a pressure gas reservoir, and at least one consumer port operative to provide pressure gas to a pressure gas consumer (such as a brake cylinder).

Thereby, the control device is configured for use in applications (such as brake systems, levelling systems, or other vehicle systems) in which it is particularly desirable to provide ingress reduction and/or reduce PCB movement during control device operation using a control device configuration that allows weight benefits to be attained and/or that provides enhanced versatility in positioning and dimensioning strip(s) of foam materials.

According to a further aspect, there is provided a vehicle comprising a pneumatic vehicle system, wherein the pneumatic vehicle system comprises the control device, the vehicle brake valve or the pressure modulator according to any aspect or embodiment disclosed herein.

Thereby, the effects discussed in detail herein are attained in association with a pneumatic vehicle system (such as a brake system, levelling system, or other vehicle system) in which it is particularly desirable to provide ingress reduction and/or reduce PCB movement during control device operation using a control device configuration that allows weight benefits to be attained and/or that provides enhanced versatility in positioning and dimensioning strip(s) of foam materials.

According to a further aspect, there is provided a method of manufacturing a control device for a vehicle. The method comprises forming a first housing component and a second housing component. Forming the first housing component comprises dispensing a foam material onto a molded part along a structural feature of the molded part to form at least one strip of foam material. The method further comprises arranging a PCB in between the first housing component and the second housing component. The method further comprises engaging the first housing component with the second housing component such that the PCB is arranged in a housing cavity defined by the first housing component and the second housing component.

Various effects and advantages are attained by the manufacturing method. By providing the at least one strip of foam material that adheres on the molded part, it is possible for the first housing component to be formed prior to assembly of the first and second housing components with the PCB. By providing the at least one strip of foam material that adheres on the molded part, greater flexibility is attained in positioning the foam material as compared to constructions that rely on a friction fitting compression of the foam material. This offers various concomitant effects, such as allowing the at least one strip of foam material to be arranged on an end face of at least one projection of the structural feature and/or allowing the at least one strip of foam material to be arranged in a groove that does not need to have continuous planar walls to compress the strip of foam material within the groove.

The first housing component may comprise or may be one of a cover and frame of the housing. The second housing component may comprise or may be the other one of the cover and frame of the housing.

Dispensing the foam material onto the molded part may comprise dispensing the foam material from a discharge needle to form the at least one strip of foam material adhering on the molded part.

Thereby, the at least one strip of foam material does not need to be formed as a structural component that is subsequently assembled to the molded part. The manufacturing process is simplified.

Dispensing the foam material onto the molded part may comprise dispensing the foam material such that the at least one strip of foam material is free from mechanical preloading by the molded part prior to assembly of the first and second housing components and the PCB.

Thereby, the at least one strip of foam material disposed on the molded part is available in its uncompressed state for performing functions such as sealing, mechanically securing the PCB, vibration damping, or other.

Dispensing the foam material onto the molded part may comprise dispensing the foam material such that the at least one strip of foam material adheres to the molded part by an adhesion force of the foam material on the molded part.

Thereby, greater flexibility is attained in positioning the foam material as compared to constructions that rely on a friction fitting compression of the foam material. This offers various concomitant effects, such as allowing the at least one strip of foam material to be arranged on an end face of at least one projection of the structural feature and/or allowing the at least one strip of foam material to be arranged in a groove that does not need to have continuous planar walls to delimit the groove.

Dispensing the foam material onto the molded part may comprise dispensing the foam material such that the at least one strip of foam material is in direct abutment with the molded part without a glue being interposed between the at least one strip of foam material and the molded part.

Thereby, manufacture of the first housing component is facilitated. It is not required to dispose a glue layer on the molded part to adhere the at least one strip of foam material to the molded part.

The molded part and the at least one strip of foam material may form an integral unit.

Thereby, assembly of the first and second housing components and the PCB to is facilitated. It is not required for the at least one strip of foam material to be handled as a separate component upon assembly of the first and second housing components and the PCB.

Additional features of the manufacturing method and the effects attained thereby correspond to features disclosed in association with the control device. For illustration, the molded part may comprise a ribbed structural feature (such as a ribbed projection comprising several ribs spaced from each other), and dispensing the foam material may comprise dispensing the foam material on or otherwise along the ribbed structural feature to form the at least one strip of foam material. Dispensing the foam material may comprise dispensing the foam material on a free end face of a ribbed projection.

Assembling the first housing component, the second housing component, and the PCB may comprise assembling the first housing component, the second housing component, and the PCB such that a strip of foam material of the at least one strip of foam material abuts on the PCB to reduce movement of the PCB relative to the housing.

Assembling the first housing component, the second housing component, and the PCB may comprise assembling the first housing component, the second housing component, and the PCB such that a strip of foam material of the at least one strip of foam material abuts on the second housing component to reduce or eliminate foreign matter ingress into the housing cavity.

The manufacturing method may be or may comprise a method of manufacturing the control device according to any one aspect or embodiment disclosed herein.

The manufacturing method may be performed by or using a manufacturing system that comprises a foam dispensing needle operative to dispense foam onto the molded part.

According to a further aspect, there is provided a method of assembling a pneumatic vehicle system or a vehicle comprising a pneumatic vehicle system, wherein the method comprises installing the control device according to any one aspect or embodiment disclosed herein. The pneumatic vehicle system may comprise a brake system (such as an electronic brake system (EBS), a levelling system, and/or another pneumatic system), in which the control device is installed. The method of assembling the pneumatic vehicle system or the vehicle may further comprise performing the method of manufacturing the control device according to any aspect or embodiment disclosed herein.

Various effects and advantages are attained by the control devices, systems, and methods disclosed herein. For illustration, the control device and manufacturing method provides enhanced flexibility in positioning the at least one strip of foam material, does not require a force fit or glue layer for attachment of the at least one strip of foam material on the molded part, and thereby facilitates assembly of the control device.

Further advantages and embodiments are defined in the claims. These and other aspects of the invention will be apparent from and explained in more detail with reference to the embodiments described hereafter with reference to the accompanying drawings, in which:
Fig. 1 is an exploded view of a control device according to an embodiment;
Fig. 2 is a partial view of the control device of Fig. 1;
Fig. 3 is a cross-sectional view of the control device of Fig. 1;
Fig. 4 is a schematic cross-sectional representation of a detail of Fig. 3;
Fig. 5 is a partial perspective view of a housing component of the control device of Fig. 1;
Fig. 6 is a partial perspective view of a housing component of the control device of Fig. 1;
Fig. 7 is a partial broken-away view of the control device of Fig. 1;
Fig. 8 is a partial perspective view of a housing component of the control device according to a further embodiment;
Fig. 9 is a partial perspective view of a housing component of the control device according to yet a further embodiment;
Fig. 10 is a partial perspective view of a structural feature of the housing component of Fig. 8 or Fig. 9;
Fig. 11 is a schematic representation of a manufacturing system configured to manufacture the control device according to an embodiment;
Fig. 12 is a flow chart of a method according to an embodiment;
Fig. 13 is a flow chart of a method according to a further embodiment;
Fig. 14 is a schematic representation of a utility vehicle comprising a control device according to an embodiment;
Fig. 15 is a perspective view of a control device according to an embodiment;
Fig. 16 is a schematic representation of a vehicle system or a vehicle brake system comprising the control device according to an embodiment;
Fig. 17 is a flow chart of a method according to another embodiment; and
Fig. 18 is a flow chart of a method according to yet another embodiment;

Embodiments of the invention will be described with reference to the drawings. In the drawings, similar or identical reference signs designate elements with similar or identical configuration and/or function.

To avoid repetition in the Figures and the description of the various aspects and illustrative embodiments, it is be understood that many features are common to several aspects and embodiments. Omission of an aspect from a description or Fig. does not imply that the aspect is missing from embodiments that incorporate that aspect. Instead, the aspect may have been omitted for clarity. Like numbers in two or more figures represent the same or similar elements.

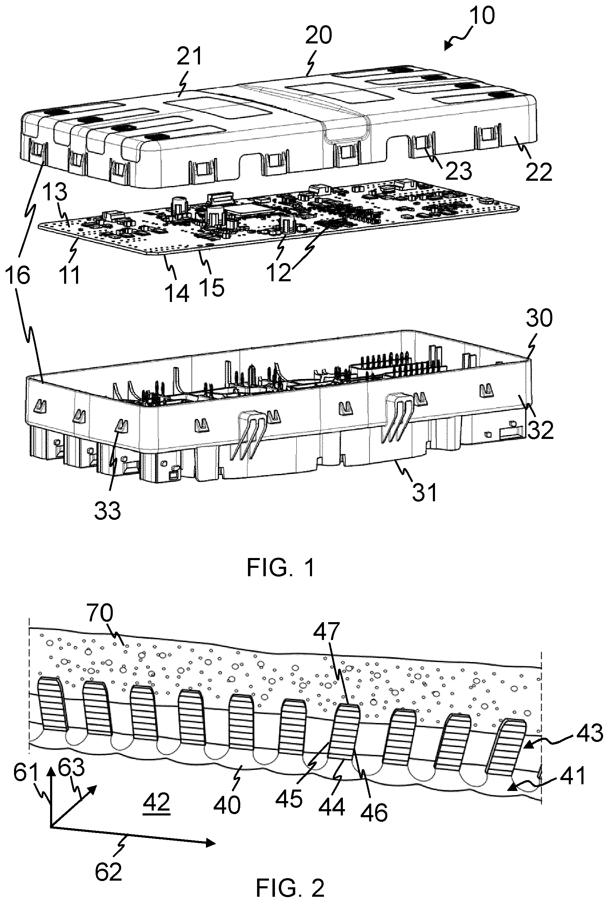

Fig. 1 shows an exploded perspective view of a control device 10 for a vehicle, such as a commercial vehicle or other utility vehicle. Partial and/or cross-sectional views of the control device 10 are shown in Fig. 2, Fig. 3, Fig. 4, Fig. 5, Fig. 6, Fig. 7, Fig. 8, Fig. 9, and Fig. 10, to which reference will be made hereinbelow. The control device 10 comprises a housing 16 and a printed circuit board (PCB) 11.

The PCB 11 comprises electric components 12 mounted on a dielectric plate. The PCB 11 has a first major face 13, a second major face 14 opposite the first major face 13, and an outer minor surface 15 that extends circumferentially around the PCB 11.

The housing 16 comprises a frame 30 and a cover 20. The cover 20 is engageable with the frame 30, e.g., in a destruction-free reversibly releasable manner. The cover 20 has a cover major face 21. When the control device 10 is assembled, the cover major face 21 extends along and spaced from the first major face 13 of the PCB 11. The cover 20 has a cover sidewall portion 22. The cover sidewall portion 22 comprises a cover engagement structure 23 configured for a reversibly releasable engagement with a mating frame engagement structure 33 of the frame 30. The cover sidewall portion 22 may extend from the cover major face 21 along an entire outer periphery of the cover major face 21. The cover sidewall portion 22 is operative to overlap a frame sidewall portion 32 when the cover 20 is assembled with the frame 30.

The frame 30 has a frame major face 31. When the control device 10 is assembled, the frame major face 31 extends along and spaced from the second major face 14 of the PCB 11. The frame 30 has the frame sidewall portion 32. The frame sidewall portion 32 comprises the frame engagement structure 33 configured for a reversibly releasable engagement with the cover engagement structure 23. The frame sidewall portion 32 may extend from the frame major face 31 along an entire outer periphery of the frame major face 31.

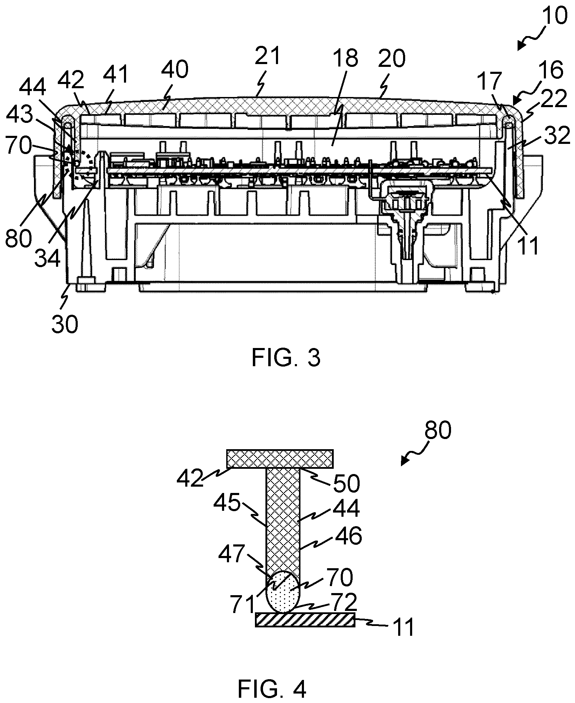

In the control device 10, the cover 20 and the frame 30 are engaged with each other and define a housing cavity 18 (shown in Fig. 3) therebetween. The PCB 11 is arranged in the housing cavity 18.

As described in more detail herein, at least one of the cover 20 and the frame 30 comprises a molded part with at least one strip of foam material adhering to the molded part. The molded part may comprise a structural feature that comprises or is delimited by a ribbed projection. The at least one strip of foam material adhering on the molded part along the ribbed projection, e.g., on an end face of the ribbed projection.

Fig. 2 shows a partial perspective view of the control device 10. At least one of the cover 20 and the frame 30 comprises a molded part 40 and at least one strip of foam material 70 adhering on the molded part 40. While configurations will be described with reference to Fig. 2, Fig. 3, Fig. 4, Fig. 5, Fig. 6, Fig. 7, Fig. 8, Fig. 9, and Fig. 10 in which a strip of foam material 70 adheres on the molded part of the cover 20 or of the frame 30, it is to be understood that (i) both the cover 20 and the frame 30 may comprise a respective molded part, and (ii) both the cover 20 and the frame 30 may respectively comprise a strip of foam material 70 adhering on the respective molded part.

The molded part 40 comprises a structural feature which may comprise a ribbed projection 43 and/or a ribbed groove. The molded part 40 has an inner surface 41 that faces towards the PCB 11. The inner surface 41 may define an inner surface region 42 from which the structural feature projects or in which the structural feature is recessed. The inner surface region 42 may be planar or substantially planar in at least a portion of the inner surface 41 that surrounds a base end 50 of the ribbed projection 43.

A strip of foam material 70 is disposed on the ribbed projection 43 and adheres on the ribbed projection 43. The strip of foam material 70 may comprise or consist of a material that adheres on the molded part 40. The strip of foam material 70 may comprise or consist of a silicone-based foam material, such as a foam material comprising a silicone rubber, without being limited thereto.

The structural feature may have a variety of different configurations, such as a ribbed projection and/or a ribbed groove. The ribbed projection 43 may comprise several ribs 44. Each of the several ribs 44 may project along a first direction 61 from the inner surface region 42. The first direction 61 may be transverse to, e.g., perpendicular to or substantially perpendicular to a plane defined by the inner surface region 42. Adjacent ribs of the several ribs 44 are spaced from each other along a second direction 62. The second direction 62 may be perpendicular to the first direction 61 or substantially perpendicular to the first direction 61. The second direction 62 may be parallel or substantially parallel to a plane along which the inner surface region 42 extends. The several ribs 44 may be arranged with equal spacing or with a varying spacing therebetween. A ribbed projection 43 having a constant rib spacing may facilitate dispensing the strip of foam material 70 thereon. A ribbed projection 43 having a varying rib spacing allows a degree of support provided upon resilient compression of the at least one strip of foam material 70 to be spatially varying, providing enhanced versatility of use.

The several ribs 44 each have an end face 47. The end face 47 may be arranged spaced from the base end 50 along the first direction 61. The end face 47 may comprise a curved surface, such as a cylindrical portion, to increase the area over which the strip of foam material 70 adheres to the molded part. Each of the several ribs 44 may comprise rib walls 45, 46 spaced along the second direction 62. The rib walls 45, 46 may extend substantially transverse to the second direction 62. The ribs 44 each have a width measured along a third direction 63 that is perpendicular to the first direction 61 and the second direction 62. The width of the ribs 44 is greater than a width of an interconnecting ledge extending between the ribs 44, if such an interconnecting ledge is present. Thus, the ribbed projection 43 is a structural feature that has a width, measured along the third direction 63, which varies as a function of position along the second direction 62.

The control device 10 may comprise a structural feature comprising a ribbed projection and/or a ribbed groove with a strip of foam material disposed therealong at any one or any set of locations of the cover 20 and/or the frame 30. For illustration, the control device 10 may comprise a cover 20 that comprises a molded part having a ribbed projection 43 and at least one strip of foam material 70 adhering on the ribbed projection 43 arranged such that the strip of foam material 70 abuts on the PCB 11 to dampen (i.e., reduce an amplitude of e.g., vibrations) displacement of the PCB 11 caused by, e.g., vibrations. The cover 20 and/or the frame 30 may comprise several ribbed projections and several strips of foam material adhering thereon to reduce or eliminate foreign matter ingress into the housing cavity 18. The cover 20 and/or the frame 30 may comprise several ribbed projections and several strips of foam material adhering thereon to assist in securing the PCB 11 in place. Alternatively or additionally, the cover 20 and/or the frame 30 may comprise a ribbed groove (e.g., a groove delimited by a corrugated surface on one side or a groove otherwise having spatially varying width), with strip(s) of foam material 70 adhering on the molded part and disposed in the ribbed groove.

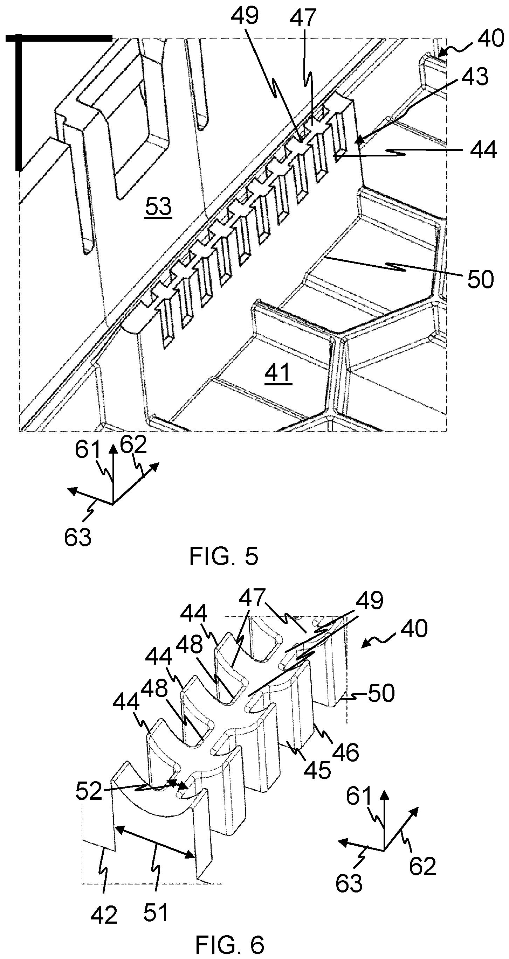

Fig. 3 and Fig. 4 show an embodiment of the control device 10 of Fig. 1 and Fig. 2 in a cross-sectional representation. Fig. 5 and Fig. 6 show geometric features of the molded body of the control device 10.

Fig. 3 show an embodiment of the control device 10 which comprises a damping mechanism for reducing or eliminating the risk of the PCB 11 being displaced in an undesired manner relative to a support structure 34. The cover 20 comprises the molded part 40 having the ribbed projection 43. The cover 20 comprises the strip of foam material 70 adhering to the ribbed projection 43 at an end face of the ribbed projection 43, wherein the end face is arranged to extend in proximity to the first major face 13 of the PCB 11. The strip of foam material 70 is operative to reduce the risk of the PCB 11 being displaced relative to the support structure 34, thereby acting as the damping mechanism operative to reduce or eliminate the risk of the PCB 11 being displaced in an undesired manner relative to a support structure 34.

The control device 10 may comprise a seal 17 disposed adjacent the cover sidewall portion 22 and engaged with the frame sidewall portion 32. The cover 20 and the frame 30 may define a tortuous path to mitigate or reduce foreign matter ingress into the housing cavity 18. The seal 17 may further reduce the risk of foreign matter ingress into the housing cavity 17. The seal 17 may be arranged to extend along a corrugated surface, such as the ribbed projection 43. The seal 17 may be formed by at least one strip of foam material that adheres to the molded part 40 and, during manufacture of the cover 20, may be dispensed directly onto the molded part 40.

Fig. 4 shows a detail 80 of the cross-sectional view of Fig. 3. The strip of foam material 70 is arranged on the curved end face 47 of several ribs 44 of the ribbed projection 43. The strip of foam material 70 may be formed by dispensing the foam material from a needle of a foam dispensing system directly onto the ribbed projection 43, without a glue layer interposed between the foam material and the molded body 40. The strip of foam material 70 adheres to the curved end face 47. The curved end face 47 is spaced from the base end 50 of each rib 44 at which the rib 44 projects from the inner surface region 42. The strip of foam material 70 comprises a first portion 71 that covers, abuts, and adheres on the curved end face 47 of each of several ribs 44 of the ribbed projection 43. The strip of foam material 70 comprises a second portion 72 arranged to abut on the PCB 11 and provide a reactive force to urge the PCB 11 in position on the support structure 34 if the PCB 11 experiences vibrations, such as vibrations caused by movement of a vehicle and/or vibrations at the vehicle chassis or vehicle frame.

Fig. 5 and Fig. 6 show a partial exploded view of the cover 20 or the frame 30, with the strip of foam material 70 removed therefrom. The ribbed projection 43 extends along the second direction along a sidewall 53 of the molded part 40 (such as a sidewall of the cover sidewall portion 22 or the frame sidewall portion 32). The ribbed projection 43 comprises several ribs 44, with adjacent ribs 44 being interconnected by an interconnecting ledge 48. The interconnecting ledge 48 has an interconnecting ledge end face 48 that extends between the curved end faces 47 of the adjacent ribs 44. The interconnecting ledge 48 may have a ledge width 52 (measured along the third direction 63) which is smaller than a rib width 51 (measured along the third direction 63) of each of the several ribs 44. The strip of foam material (omitted in Fig. 5 and Fig. 6 for visibility of the rib end faces 47 and the interconnecting ledge end faces 49) extends on and adheres to the rib end faces 47 and the interconnecting ledge end faces 49.

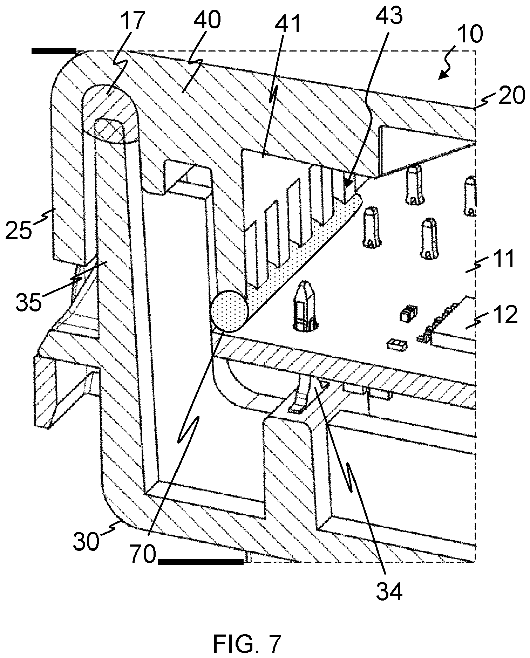

Fig. 7 shows a partially broken-away view of the control device 10, with the cover 20 comprising the molded part 40 and the strip(s) of foam material 70 adhering on the ribbed projection 43. The strip(s) of foam material 70 are arranged to abut on the PCB 11 and provide a reactive force to urge the PCB 11 in position on the support structure 34 if the PCB 11 experiences vibrations, such as vibrations caused by movement of a vehicle and/or engine vibrations. In the implementation of Fig. 7, the seal 17 is interposed between a sidewall 25 of the cover 20 and a sidewall 35 of the frame 30, which may have planar surfaces.

While an embodiment has been described in detail with reference to Fig. 2, Fig. 3, Fig. 4, Fig. 5, Fig. 6, and Fig. 7 in which the housing 16 comprises a strip of foam material 70 arranged and adhering on an end face of a ribbed projection 43, other configurations may be implemented.

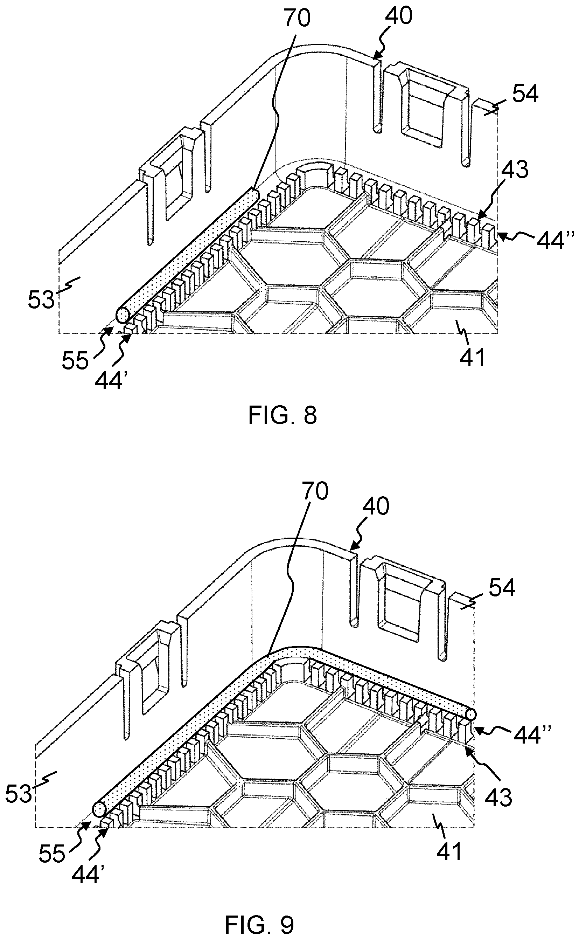

Fig. 8, Fig. 9, and Fig. 10 are partial perspective views of further embodiments, in which the cover 20 and/or the frame 30 comprises a molded part 40 having a structured groove 44, in particular a ribbed groove 55. The ribbed groove 55 may extend along a second direction 62 (e.g., parallel to a sidewall 53 of the molded part 40 and/or parallel to another sidewall 54 of the molded part 40 angled relative to the sidewall 53). On at least one of its lateral sides, the ribbed groove 55 may be delimited by a corrugated surface. The corrugated surface may be formed by a ribbed projection 43 comprising one or several sets of ribs 44', 44" which project from an inner surface 41 of the molded part 40 in a first direction 61 as previously disclosed.

Fig. 8 shows an embodiment in which a strip of foam material 70 extends in the groove 55 and along the ribbed projection comprising the set of ribs 44'. The strip of foam material 70 adheres on the molded part 40. The strip of foam material 70 may abut on ribs of the set of ribs 44' but does not need to be retained in a friction fit by the set of ribs 44' and the sidewall 53.

Fig. 9 shows an embodiment in which a strip of foam material 70 extends in the groove 55 and along the ribbed projection comprising both the set of ribs 44' arranged along the sidewall 53 and the set of ribs 44" arranged along the other sidewall 54 angled relative to the sidewall 53. The strip of foam material 70 adheres on the molded part 40. The strip of foam material 70 may abut on ribs of the sets of ribs 44', 44' but does not need to be retained in a friction fit by the set of ribs 44' or 44" and the sidewall 53 or 54.

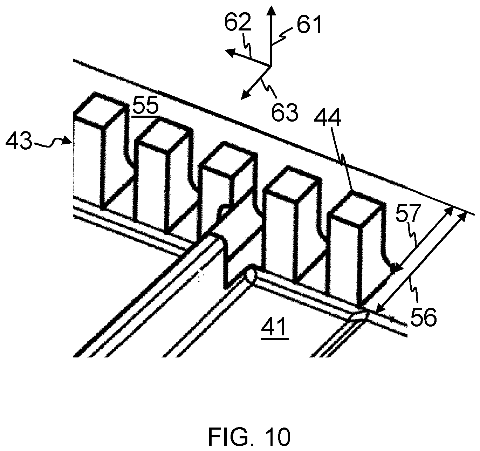

Fig. 10 shows an enlarged view of the groove 55 that is a structural feature of the molded part 40. The strip of foam material 70 is omitted for better visibility of the geometrical characteristics of the groove 55. The groove 55 is recessed relative to an inner surface 41 of the molded part (with the inner surface 41 being a surface facing towards the PCB 11) along a first direction 61 transverse to a plane of the inner surface 41. The groove 55 extends along a second direction 62 perpendicular to the first direction 61. The second direction 62 may be parallel to and extend along a sidewall 53, 54 of the molded part. The groove 55 has a width, measured along a third direction 63 perpendicular or substantially perpendicular to the first direction 61 and the second direction 62. The width varies along the second direction 62. The variable groove width may vary between a first groove width 56 and a second groove width 57, with the variation being caused by the ribbed projection formed along the groove 55.

The strip of foam material 70 disposed in a groove 55 delimited on one side by a series of ribs may be operative to provide, e.g., an ingress seal. For illustration, the strip of foam material 70 disposed in the groove 55 may be provided in the cover 20 and may engage the frame 30 to provide an ingress seal when the cover 20 and the frame 30 are engaged.

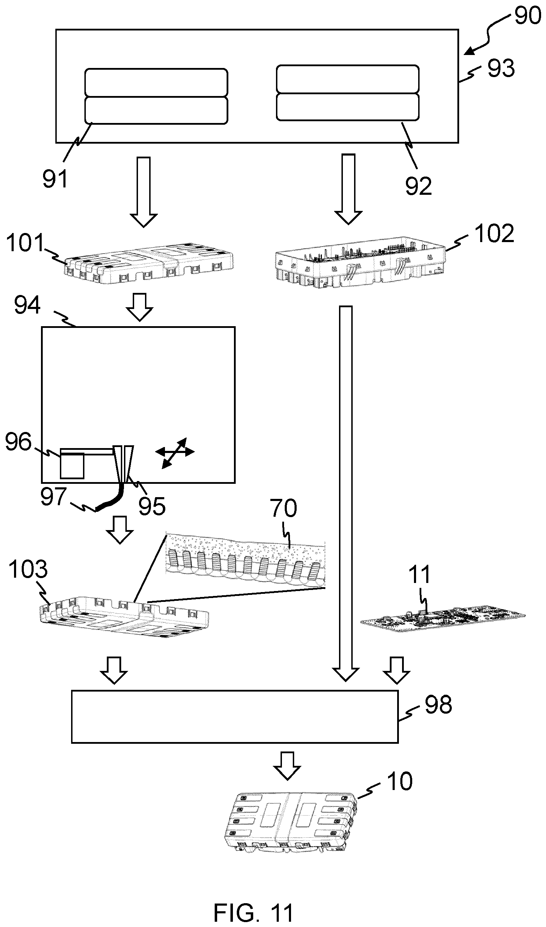

Fig. 11 is a schematic view of a manufacturing system 90 for manufacturing the control device 10. The manufacturing system 90 is operative to dispense foam material 97 directly onto a molded part to form the at least one strip of foam material 70 extending along a structural feature of a molded part of a cover 20 and/or of a frame 30 of the control device 90.

The manufacturing system 90 may comprise at least one molding station 93 to form a first molded part 101 (such as a molded part of the cover 20) using a first mold 91 and to form a second molded part 102 (such as a molded part of the frame 30) using a second mold 93. The manufacturing system 90 comprises a foam dispensing system 94. The foam dispensing system 94 comprises a foam dispensing needle 95 operative to dispense foam material 97 directly onto the first molded part 101 and/or the second molded part 102. The foam dispensing system 94 comprises an actuator 96 operative to effect a relative displacement between the foam dispensing needle 95 and the molded part onto which the foam material 97 is dispensed. The actuator 96 may be operative to displace the foam dispensing needle 95 relative to the first molded part 101 to form the at least one strip of foam material 70 adhering on, e.g., a ribbed projection 43 of the first molded part 101. The actuator 96 may be operative to displace the foam dispensing needle 95 relative to the first molded part 101 to form the at least one strip of foam material 70 adhering on the curved end face 47 of several ribs 44 of the ribbed projection 43. Alternatively or additionally, the actuator 96 may be operative to displace the foam dispensing needle 95 relative to the first molded part 101 and/or the second molded part 102 to form at least one strip of foam material 70 adhering on the respective molded part and extending in a groove 55 that is delimited on at least one of its sides by a corrugated surface that may be provided by, e.g., a set of ribs 44', 44". The manufacturing system 90 comprises an assembly station 98 operative to assemble the cover 20 (which may comprise the first molded part 101 with the strip(s) of foam material 70 disposed thereon), the frame 30 (which may comprise the second molded part 102), and the PCB 11 to form the control device 10.

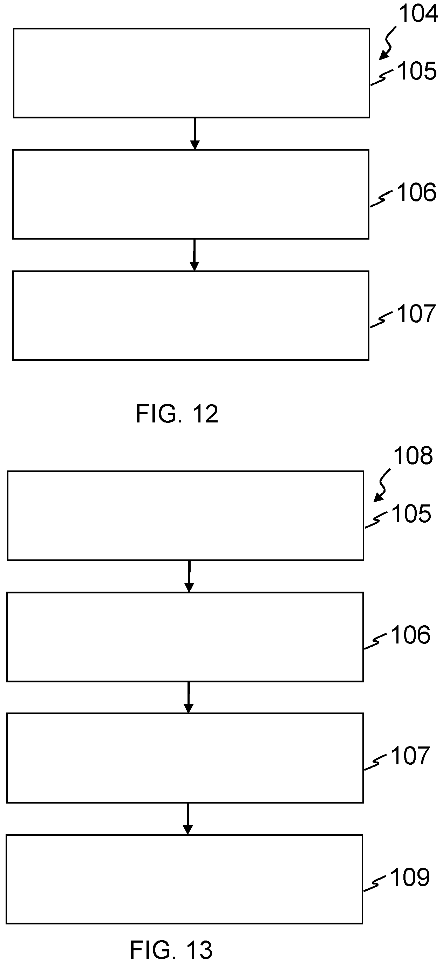

Fig. 12 is a flow chart of a method 104 of manufacturing the control device 10. The method 104 may be performed by or using the manufacturing system 90. The method 104 comprises forming, at step 105, a molded part. The molded part may have a structural feature that may comprise a ribbed projection or a groove delimited on at least one side by a ribbed projection. The method comprises dispensing, at step 106, foam material onto the molded part to form a strip of foam material 70 along (e.g., on the end faces 47 of several ribs 44) the structural feature. The method comprises assembling, at step 107, the molded part that has the strip of foam material 70 adhering thereto with at least one additional housing component (e.g., with the other one of the cover 20 and the frame 30) and the PCB 11.

Fig. 13 is a flow chart of a method 108 of manufacturing the control device 10. The method 108 comprises steps 105, 106, and 107 that may be implemented as disclosed in association with Fig. 11. The method 108 further comprises a step 109 of installing the control device 10 in a vehicle, such as a utility vehicle or other commercial vehicle. Step 109 may comprise installing the control device 10 as part of a pneumatic vehicle system, such as a brake system or levelling system. Step 109 may comprise establishing pneumatic and/or electric connections between the control device 10 and other components of the pneumatic vehicle system.

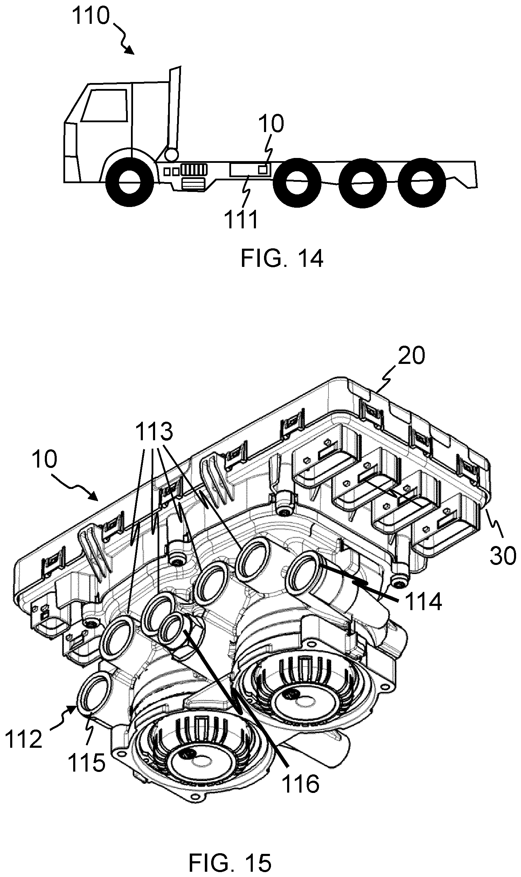

Fig. 14 is schematic representation of a vehicle 110 according to an embodiment. The vehicle 110 comprises a pneumatic vehicle system 111. The pneumatic vehicle system 111 comprises the control device 10 which may have any one of the configurations disclosed herein.

The control device 10 may comprise electrical and/or pneumatic interfaces. The control device 10 may be configured as a modulator operative to receive a control pressure at a control input port and, responsive thereto, change a pressure in one or several brake valves, one or several levelling valves, or other pneumatic actuators. The control device 10 may comprise at least one electric interface operative to receive control signals and/or sensor signals, with the PCB 11 being operative to provide processing functionality for the control signals and/or sensor signals.

Fig. 15 is a perspective view of a control device 10 configured as a modulator. The modulator 10 comprises a housing comprising the cover 20 engaged with the frame 30. The modulator 10 comprises the PCB 11 accommodated in a housing cavity 18 of the housing. The control device comprises a plurality of pneumatic ports 112. The pneumatic ports 112 may comprise supply ports 113 operative to provide pressure gas to pneumatic components (such as one or several brake valves, one or several levelling valves, or other pneumatic actuators) and/or to receive gas from the pneumatic components. The pneumatic ports 112 may comprise one or several input ports 114, 115 operative to receive the pressure gas from a pressure gas source, e.g., from a pressure gas reservoir. The pneumatic ports 112 may comprise a control input port 116 operative to receive a pneumatic control input from, e.g., a brake signal transmitter (BST). The control device 10 may comprise one or several relay valves operative to selectively establish fluid communication between one or several of the supply ports 113 and one or several of the input port(s) 114, 115 or to vent the pneumatic components via the control device 10.

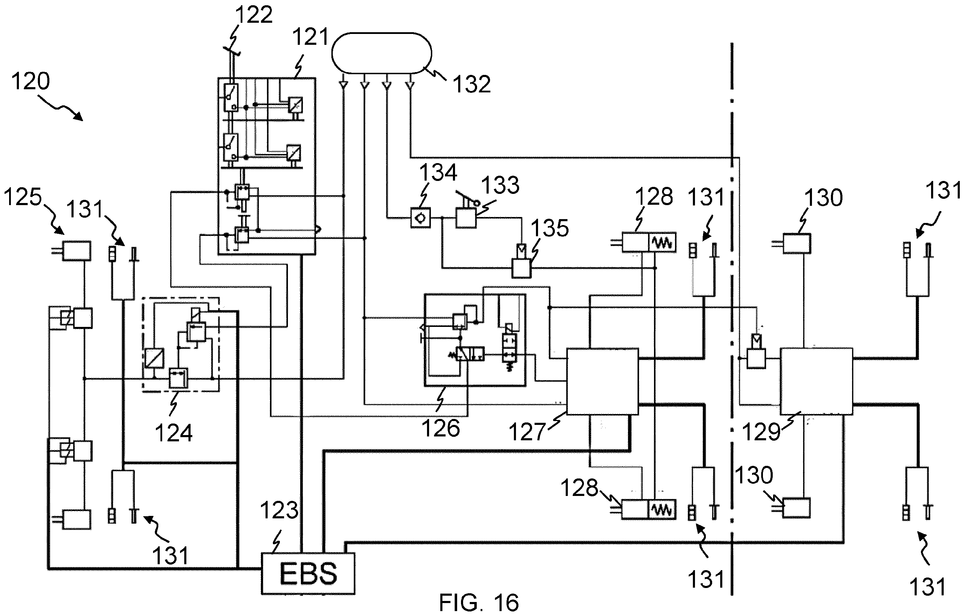

Fig. 16 shows a pneumatic vehicle system 120 configured as a brake system. The brake system comprises a BST 121. An actuating element 122, for example a pedal, can be arranged on the BST 121 or coupled thereto. An electronic brake system (EBS) 123 may be coupled to the BST 121 to generate commands for the BST 121 and/or modulators 124, 127, 129 depending on, for example, sensor signals or sensor data acquired by sensors 131.

The braking system includes a plurality of modulators 124, 127, 129, each of which is configured to convert a control pressure into a pressure in a working circuit. One, more, or all of these modulators may have the configuration of the control device 10 disclosed herein. The modulator 124 may be arranged and connected to increase a pressure in brake cylinders 125 of a front axle by connection to a source of pressurized gas, or to decrease a pressure by venting Alternatively or additionally, a modulator 127 may be provided that is configured as a rear axle modulator and is configured and connected to separately affect a pressure in brake cylinders 128 of a rear axle. Alternatively or additionally, a modulator 129 may be provided which is configured as a further rear axle modulator and is arranged and connected to separately influence a pressure in further brake cylinders 130 of a further rear axle.

One, more or all of the modulators 124, 127, 129 may have the configuration of a control device 10 as disclosed herein.

The brake system may comprise additional brake system components, as will be appreciated by the skilled person. A pressure gas supply 132 may be arranged and connected to provide pressure gas to the pressure gas inputs of the modulators 124, 127, 129. The brake system may comprise various additional pneumatic components such as control valves 133,135 or one or more check valves 134.

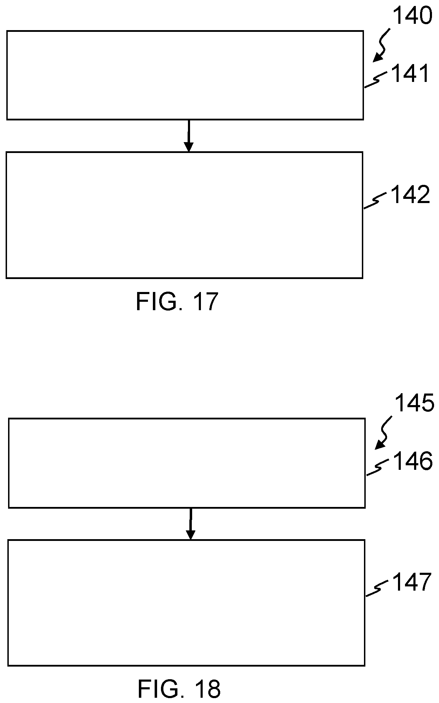

Fig. 17 is a flow chart of a method 140 of manufacturing a control device 10. The method 140 may be performed by or using the manufacturing system 10. The method comprises a step 141 of obtaining at least first and second housing components (e.g., the cover 20 and the frame 30) of a housing 16 of the control device 10. At least one of the housing components comprises a molded part 40 having a structural feature (such as a ribbed projection 43 or a groove 55 delimited by a corrugated surface that may be provided on a ribbed projection 43), with at least one strip of foam material 70 being disposed along the structural feature. The method 140 comprises a step 142 of assembling the control device 10. Assembling the control device 10 at step 142 comprises securing the PCB 11 against vibrations by placing the strip of foam material 70 into abutment with the PCB 11 when assembling the control device 10.

Fig. 18 is a flow chart of a method 145 of manufacturing a control device 10. The method 145 may be performed by or using the manufacturing system 10. The method comprises a step 146 of obtaining at least first and second housing components (e.g., the cover 20 and the frame 30) of a housing 16 of the control device 10. At least one of the housing components comprises a molded part 40 having a structural feature (such as a ribbed projection 43 or a groove 55 delimited by a corrugated surface that may be provided on a ribbed projection 43), with at least one strip of foam material 70 being disposed along the structural feature. The method 145 comprises a step 147 of assembling the control device 10. Assembling the control device 10 at step 147 comprises using the strip of foam material 70 to provide an ingress seal of the control device 10.

Various effects and advantages are attained by embodiments of the invention. For illustration, embodiments provide enhanced flexibility in positioning a resilient material on a molded part of the control device while affording ease of assembly. It is not required to attach the strip of foam material to a molded part by a frictional fit and/or using a glue. The techniques disclosed herein can be used in various control devices, such as a control device comprising a damping mechanism to reduce or eliminate PCB vibrations, wherein the damping mechanism comprises the strip(s) of foam material, and/or a control device comprising an ingress seal to reduce or eliminate foreign matter ingress into a housing cavity, wherein the ingress seal comprises the strip(s) of foam material.

Various modifications may be made in additional embodiments. For illustration, while the strip of foam material may be formed from a silicone rubber, other materials may be used.

The disclosure also covers all further features shown in the drawings individually although they may not have been described in the afore or following description. Also, single alternatives of the embodiments described in the figures and the description and single alternatives of features thereof can be disclaimed from the subject matter of the invention or from disclosed subject matter. The disclosure comprises subject matter consisting of the features defined in the claims or the exemplary embodiments as well as subject matter comprising said features.

Furthermore, the word "comprising" does not exclude other elements or steps, and the indefinite article "a" or "an" does not exclude a plurality. A single unit or step may fulfil the functions of several features recited in the claims. The mere fact that certain measures are recited in mutually different dependent claims does not indicate that a combination of these measures cannot be used to advantage. The terms "essentially", "about", "approximately", "substantially" and the like in connection with an attribute or a value particularly also define exactly the attribute or exactly the value, respectively. The term "substantially" refers to a value or range that is, e.g., within 20%, within 10%, within 5%, or within 2% of the given value or range. Components described as coupled or connected may be electrically or mechanically directly coupled, or they may be indirectly coupled via one or more intermediate components. Any reference signs in the claims should not be construed as limiting the scope.

### List of Reference Numerals (part of the description)

- 10: control device
- 11: printed circuit board (PCB)
- 12: electrical components
- 13: first major face
- 14: second major face
- 15: outer surface
- 16: housing
- 17: seal
- 18: housing cavity
- 20: cover
- 21: cover major face
- 22: cover sidewall portion
- 23: cover engagement structure
- 25: sidewall
- 30: frame
- 31: frame major face
- 32: frame sidewall portion
- 33: frame engagement structure
- 34: support structure
- 35: sidewall
- 40: molded part
- 41: inner surface
- 42: inner surface region
- 43: ribbed projection
- 44: rib
- 44': set of ribs
- 44": further set of ribs
- 45, 46: rib wall
- 47: end face
- 48: interconnecting ledge
- 49: interconnecting ledge end face
- 50: base end
- 51: rib width
- 52: ledge width
- 53: molded part sidewall
- 54: further molded part sidewall
- 55: groove
- 56: first groove width
- 57: second groove width
- 61: first direction
- 62: second direction
- 63: third direction
- 70: strip of foam material
- 71, 72: foam strip portion
- 80: detail
- 90: manufacturing system
- 91: first mold
- 92: second mold
- 93: molding station
- 94: foam dispensing system
- 95: foam dispensing needle
- 96: actuator
- 97: dispensed foam
- 98: assembly station
- 101: first molded part
- 102: second molded part
- 103: housing component
- 104: method
- 105-107: method steps
- 108: method
- 109: method step
- 110: utility vehicle
- 111: pneumatic vehicle system
- 112: pneumatic ports
- 113: supply ports
- 114, 115: input port
- 116: control input port
- 120: pneumatic vehicle system
- 121: brake signal transmitter
- 122: actuation member
- 123: electronic brake system
- 124: modulator
- 125: front axle brake cylinder
- 126: redundancy valve
- 127: axle modulator
- 128: brake cylinder
- 129: further axle modulator
- 130: brake cylinder
- 131: sensors
- 132: pressure gas reservoir
- 133: control valve
- 134: check valve
- 135: further control valve
- 140: method
- 141, 142: method steps
- 145: method
- 146, 147: method steps

## Claims

1. Control device (10) for a vehicle (110), comprising:
a printed circuit board, PCB (11), and
a housing (16) comprising a frame (30) and a cover (20) configured for engagement with the frame (30), wherein the frame (30) and the cover (20) define a housing cavity (18) configured to house the PCB (11) therein,
wherein at least one of the frame (30) or the cover (20) comprises a molded part (40), wherein the molded part (40) has an inner surface (41) facing towards the housing cavity (18), and the molded part (40) comprises at least one structural feature (43; 55) that projects from or is recessed in the inner surface (41),
**characterized in that**
the housing (16) comprises at least one strip of foam material (70) that adheres to the molded part (40).

2. Control device (10) for a vehicle (110) of claim 1, wherein the at least one strip of foam material (70) adheres to the molded part (40) by an adhesion force of the foam material on the molded part (40).

3. Control device (10) for a vehicle (110) of claim 2, wherein the at least one strip of foam material (70) is in direct abutment with the molded part (40) without a glue being interposed between the at least one strip of foam material (70) and the molded part (40).

4. Control device (10) for a vehicle (110) of claim 2 or claim 3, wherein the molded part (40) and the at least one strip of foam material (70) form an integral unit (20, 30).

5. Control device (10) for a vehicle (110) of any one of the preceding claims, wherein the at least one strip of foam material (70) comprises a strip of foam material (70) arranged to reduce or eliminate foreign matter ingress into the housing cavity (18).

6. Control device (10) for a vehicle (110) of claim 5, wherein the strip of foam material (70) arranged to reduce or eliminate foreign matter ingress is comprised by one of the frame (30) and the cover (20) and abuts on the other one of the frame (30) and the cover (20).

7. Control device (10) for a vehicle (110) of any one of the preceding claims, wherein the at least one strip of foam material (70) comprises a strip of foam material (70) in abutment with the PCB (11).

8. Control device (10) for a vehicle (110) of claim 7, wherein the PCB (11) has a first major face (13) and a second major face (14) parallel to the first major face (13), wherein the strip of foam material (70) in abutment with the PCB (11) abuts on the first major face (13) to secure the PCB (11) with the second major face (14) of the PCB (11) abutting on at least one PCB support member (34) of the housing (16).

9. Control device (10) for a vehicle (110) of any one of the preceding claims, wherein the at least one structural feature (43; 55) comprises a ribbed structural feature (43; 55).

10. Control device (10) for a vehicle (110) of claim 9, wherein the ribbed structural feature (43; 55) projects or is recessed along a first direction (61) relative to an inner surface region (42) of the inner surface (41), wherein the ribbed structural feature (43; 55) extends along a second direction (62), wherein the first direction (61) is transverse to the inner surface region (42), wherein the second direction (62) is parallel to the inner surface region (42), and wherein the ribbed structural feature (43; 55) has a width (51, 52; 56, 57) measured along a third direction (63), wherein the third direction (63) is parallel to the inner surface region (42) and transverse to the first direction (61) and to the second direction (62), wherein the width (51, 52; 56, 57) varies as a function of position along the second direction (62).

11. Control device (10) for a vehicle (110) of claim 9 or claim 10, wherein the ribbed structural feature (43; 55) comprises a curved surface segment at an end face (47) of the ribbed structural feature (43; 55), wherein the at least one strip of foam material (70) comprises a strip of foam material (70) arranged on the curved surface segment.

12. Control device (10) for a vehicle (110) of any one of the preceding claims, wherein the at least one structural feature (43; 55) comprises a groove (55) in the molded part (40), wherein the at least one strip of foam material (70) comprises a strip of foam material (70) arranged in the groove (55).

13. Vehicle brake valve (124, 127, 129), comprising the control device (10) of any one of the preceding claims.

14. Pressure modulator (124, 127, 129) for a utility vehicle, comprising the control device (10) of any one of claims 1 to 12.

15. A method of manufacturing a control device (10) for a vehicle (110), the method comprising:
forming a first housing component (20; 101) and a second housing component (30; 102), wherein forming the first housing component (20; 101) comprises dispensing a foam material (97) onto a molded part (40) along a structural feature (43; 55) of the molded part (40) to form at least one strip of foam material (70);
arranging a printed circuit board, PCB (11), in between the first housing component (20; 101) and the second housing component (30; 102); and
engaging the first housing component (20; 101) with the second housing component (30; 102) such that the PCB (11) is arranged in a housing cavity (18) defined by the first housing component (20; 101) and the second housing component (30; 102).
